# EUROPEAN PATENT APPLICATION

(11) **EP 4 257 329 A1**
(43) Date of publication of application: **11.10.2023**
(21) Application number: 21900686.3
(22) Date of filing: 02.12.2021
(51) Int. Cl.: B29C 45/14, F28D 9/00, F28F 21/06, F28F 21/08, H01L 23/473

(54) **TEMPERATURE CONTROL UNIT AND METHOD FOR MANUFACTURING TEMPERATURE CONTROL UNIT**

(30) Priority: 02.12.2020 JP 2020200637
(71) Applicant: Mitsui Chemicals, Inc., Tokyo 104-0028 (JP)
(72) Inventor: KURIYAGAWA, Mizue, Sodegaura-shi, Chiba 299-0265 (JP); KIMURA, Kazuki, Sodegaura-shi, Chiba 299-0265 (JP); TORII, Tomoki, Tokyo 104-0028 (JP)
(74) Representative: J A Kemp LLP
(86) International application number: PCT/JP2021/044355
(87) International publication number: WO 2022/118936

(57) **Abstract**

A temperature control unit, comprising a first metal member, a second metal member, a first resin member that is disposed between the first metal member and the second metal member, and a second resin member,
the first resin member having a shape corresponding to a space for a fluid to flow between the first metal member and the second metal member, and
the second resin member being joined with at least a portion of a surface of at least one of the first metal member or the second metal member.

## Description

### [Technical Field]

The present invention relates to a temperature control unit and a method for manufacturing a temperature control unit.

### [Background Art]

As a means for cooling an object that generates heat during operation (a heating element) such as a CPU for computers or a secondary battery for electric vehicles, various types of cooling devices using a liquid-type coolant such as water are known. For example, a cooling device, having a casing made of a highly heat-dissipating material such as metal and a channel that allows a coolant to flow inside the casing, is known.

A cooling device having a configuration as described above is generally formed of metal components that are joined by brazing. In Japanese Patent Application Laid-Open No. 2015-210032, a cooling device, which is produced by a method in which either welding or spot-welding is selected for different joining portions, is proposed.

### [Summary of Invention]

### [Problem to be Solved]

Conventional cooling devices are produced by a method including joining the members that form the device by brazing, and subsequently joining a component such as a joint to a casing by brazing. Since the method requires two steps of brazing, there is the problem that the strength of the casing may decrease as a result of heat applied during brazing, in addition to the problem of a complicated manufacturing process.

Further, the internal portion of a cooling device, especially when a liquid-type coolant is used, needs to be sufficiently sealed in order to prevent a coolant from leaking out of a channel.

Moreover, there is demand for a cooling device that cools a heating element at both sides of the cooling device, or a cooling device that cools a heating element at a specific portion of the cooling device.

In view of the foregoing, the present disclosure aims to provide a temperature control unit having a tightly sealed internal portion, and a method for manufacturing the same.

### [Means for Solving Problem]

The means for solving the problem include the following embodiments.
<1> A temperature control unit, comprising a first metal member, a second metal member, a first resin member that is disposed between the first metal member and the second metal member, and a second resin member,
   the first resin member having a shape corresponding to a space for a fluid to flow between the first metal member and the second metal member, and
   the second resin member being joined with at least a portion of a surface of at least one of the first metal member or the second metal member.
<2> The temperature control unit according to <1>, wherein the second resin member is joined with at least a portion of a surface of each of the first metal member and the second metal member.
<3> The temperature control unit according to <1> or <2>, wherein the first metal member and the second metal member are not joined with the first resin member.
<4> The temperature control unit according to <1>, wherein the first resin member is fused with at least a portion of a surface of the second resin member.
<5> The temperature control unit according to <4>, wherein an interface at which at least one of the first metal member or the second metal member is joined with the second resin member, and an interface at which the first resin member and the second resin member are fused, are adjacent to each other.
<6> The temperature control unit according to any one of <1> to <5>, wherein the surface of at least one of the first metal member or the second metal member, the portion of which is joined with the second resin member, is roughened.
<7> The temperature control unit according to any one of <1> to <6>, wherein a state of joining is such that a portion of the second resin member is embedded in a concave-convex structure at the surface of at least one of the first metal member or the second metal member.
<8> The temperature control unit according to any one of <1> to <7>, wherein each of the first metal member and the second metal member independently comprises a metal selected from the group consisting of iron, copper, nickel, gold, silver, platinum, cobalt, zinc, lead, tin, titanium, chromium, aluminum, magnesium and manganese, or an alloy comprising the metal.
<9> The temperature control unit according to any one of <1> to <8>, wherein the first metal member and the second metal member comprise a metal of the same kind as, or a metal of a different kind from, each other.
<10> The temperature control unit according to any one of <1> to <9>, wherein the first resin member and the second resin member comprise a resin of a same kind.
<11> The temperature control unit according to any one of <1> to <10>, wherein the first resin member has an attachment portion for attaching the temperature control unit to a peripheral device.
<12> The temperature control unit according to <11>, wherein the attachment portion is integrally formed with a main body of the first resin member.
<13> The temperature control unit according to any one of <1> to <10>, wherein the second resin member has an attachment portion for attaching the temperature control unit to a peripheral device.
<14> The temperature control unit according to <13>, wherein the attachment portion is integrally formed with a main body of the second resin member.
<15> The temperature control unit according to any one of <1> to <10>, wherein at least one of the first metal member or the second metal member has an attachment portion for attaching the temperature control unit to a peripheral device.
<16> The temperature control unit according to <15>, wherein at least one of the first resin member or the second resin member has an attachment portion for attaching the temperature control unit to a peripheral device.
<17> The temperature control unit according to <15> or <16>, wherein the attachment portion comprises a resin and is joined with a surface of at least one of the first metal member or the second metal member.
<18> A method for manufacturing the temperature control unit according to any one of <1> to <17>, the method comprising:
   disposing the first metal member, the second metal member and the first resin member in a mold; and
   supplying a melted resin to the mold.
<19> The method for manufacturing the temperature control unit according to <18>, the method further comprising, prior to disposing the first metal member, the second metal member and the first resin member in a mold, subjecting a surface of at least one of the first metal member or the second metal member to a roughening treatment.

### [Effect of Invention]

According to the present disclosure, a temperature control unit having a tightly sealed internal portion, and a method for manufacturing the same, are provided.

### [Brief Description of Drawings]

Fig. 1 is a schematic sectional view of an example of an internal structure of a temperature control unit.
Fig. 2 is a schematic plan view of an example of an internal structure of a temperature control unit.
Fig. 3 is a schematic plan view of an example of a structure of a temperature control unit.
Fig. 4 is a schematic plan view of an example of a structure of a temperature control unit.
Fig. 5 is a schematic plan view of an example of a structure of a temperature control unit.
Fig. 6 is a schematic perspective view of an example of an external appearance of a temperature control unit.

### [Embodiment for Implementing Invention]

In the present disclosure, a numerical range indicated using "to" includes the numerical values before and after "to" as a minimum value and a maximum value, respectively.

In numerical ranges stated in a stepwise manner in the present disclosure, the upper limit value or the lower limit value stated in one numerical range may be replaced with the upper limit value or the lower limit value of another numerical range stated in a stepwise manner. Further, in the numerical range stated in the present disclosure, the upper limit value or the lower limit value of the numerical range may be replaced with the value shown in the examples.

In the present disclosure, each component may contain a plurality of substances corresponding thereto. When a plurality of substances corresponding to each component is present in the composition, the content of each component refers to the total content of the plurality of substances present in the composition, unless otherwise specified.

In the present disclosure, when an embodiment is explained by referring to a drawing, the configuration of the embodiment is not limited to a configuration shown in the drawing. Further, the size of components in the drawing is shown in a conceptual manner, and the relative relationship thereof is not limited to that shown in the drawing.

### <Temperature Control Unit>

The temperature control unit of the present disclosure is a temperature control unit, comprising a first metal member, a second metal member, a first resin member that is disposed between the first metal member and the second metal member, and a second resin member,
the first resin member having a shape corresponding to a space for a liquid to flow between the first metal member and the second metal member, and
the second resin member being joined with at least a portion of a surface of at least one of the first metal member or the second metal member.

In the present disclosure, the "temperature control unit" refers to a device that controls the temperature of an object by allowing a fluid to flow through a space that is formed inside the device. The "temperature control" includes cooling an object, warming an object, keeping an object warm, keeping an object cold, and the like.

The type of a fluid to flow through a space inside a temperature control unit is not specifically limited, and may be selected depending on the purpose of the temperature control unit. Examples of the fluid include water, organic solvent and oil.

In the present disclosure, the first metal member and the second metal member may be referred to as a "metal member" without any distinction, and the first resin member and the second resin member may be referred to as a "resin member" without any distinction.

In the temperature control unit of the present disclosure, the first resin member, which is disposed between the first metal member and the second metal member, has a shape corresponding to a space for a fluid to flow therein (hereinafter, also referred to as a channel). By disposing the first resin member between the first metal member and the second metal member, it is possible to produce a temperature control unit without processing a metal member to form a channel thereto.

Further, the temperature control unit of the present disclosure has a high degree of freedom in terms of designing an internal structure of the temperature control unit. Therefore, according to the present disclosure, it is possible to provide a temperature control unit that can be used by disposing a heating element at both sides of the temperature control unit; a temperature control unit that can be used by disposing a heating element at a specific portion of the temperature control unit; or a temperature control unit that can cool a specific portion of a heating element in a selective manner, for example, a temperature control unit that can intensively cool a portion of a heating element that generates a large amount of heat by optimizing the design of a channel.

The temperature control unit of the present disclosure has a second resin member that is joined with at least a portion of a surface of at least one of the first metal member or the second metal member.

The second resin member may be joined with at least a portion of a surface of each of the first metal member and the second metal member. In that case, the second resin member functions as a means for joining the first metal member and the second metal member. As a result, a sufficient degree of sealing is ensured inside the temperature control unit.

The first resin member may be fused with at least a portion of a surface of the second resin member. In that case, the second resin member functions as a means for joining the first resin member with at least one of the first metal member or the second metal member. As a result, a sufficient degree of sealing is ensured inside the temperature control unit, even when the first resin member is not joined with at least one of the first metal member or the second metal member.

The state in which the second resin member is joined at least a portion of a surface of the first metal member or the second metal member may be produced by, for example, injecting a melted resin for forming the second resin member into a mold in which the first metal member, the second metal member and the first resin member are disposed.

The melted resin enters a fine concave-convex structure at a surface of the first metal member and the second metal member, and becomes solidified. As a result, the second resin member, which is formed from a solidified resin, is tightly joined with the first metal member and the second metal member.

The state in which the first resin member is fused with at least a portion of a surface of the second resin member may be produced by, for example, allowing a melted resin to contact with the first resin member in the process as mentioned above. A surface of the first resin member, being in contact with a melted resin, is melted by heat of the melted resin. As a result, the second resin member, which is formed from a solidified resin, is tightly joined with the first resin member.

When the first resin member is fused with at least a portion of a surface of the second resin member, an interface at which at least one of the first metal member or the second metal member is joined with the second resin member (hereinafter, also referred to a joined interface), and an interface at which the first resin member and the second resin member are fused with each other (hereinafter, also referred to a fused interface), are preferably adjacent to each other from the viewpoint of securing a tightly sealed state inside the temperature control unit.

In the present disclosure, the state that a joined interface and a fused interface are adjacent to each other refers to a state that an edge of a joined interface and an edge of a fused interface are located without interposing a space therebetween. A joined interface and a fused interface, which are adjacent to each other, may be either at the same plane or not at the same plane.

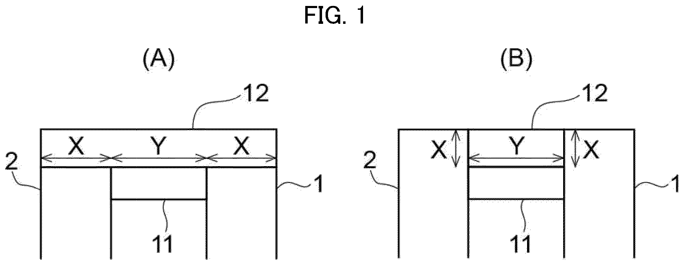

Fig. 1 shows an example of an internal structure of the temperature control unit in which a joined interface and a fused interface are adjacent to each other.

Fig. 1 (A) shows a case in which joined interfaces X at which the first metal member 1 and the second metal member 2 are joined with the second resin member 12, and a fused interface Y at which the first resin member 11 is fused with the second resin member 12, are adjacent to each other, wherein the joined interfaces X and the fused interface Y are at the same plane.

Fig. 1 (B) shows a case in which joined interfaces X at which the first metal member 1 and the second metal member 2 are joined with the second resin member 12, and a fused interface Y at which the first resin member 11 is fused with the second resin member 12, are adjacent to each other, wherein the joined interfaces X and the fused interface Y are not at the same plane.

The first metal member and the second metal member may not be joined with the first resin member. In that case, as necessary, the first metal member and the second metal member may be fixed to the first resin member in a different way, for example, using an adhesive, a screw or the like.

In the following, examples of an internal structure of the temperature control unit are described by referring to the drawings.

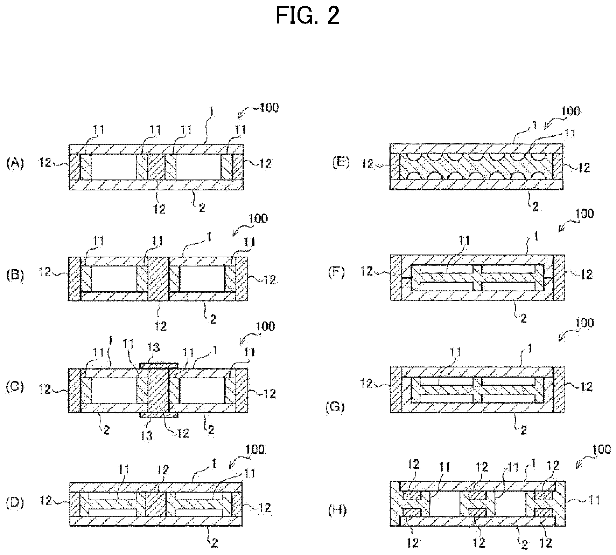

Fig. 2 is a schematic plan view of an example of an internal structure of a temperature control unit.

The temperature control unit 100, shown in Fig. 2 (A), includes the first metal member 1, the second metal member 2, the first resin member 11 that is disposed between the first metal member and the second metal member, and the second resin member 12.

The first resin member 11 is disposed between the first metal member 1 and the second metal member 2, and has a shape corresponding to a space for a fluid to flow.

The second resin member 12 is joined with at least a portion of a surface of the first metal member 1 or the second metal member 2, and is fused with at least a portion of a surface of the first resin member 11.

In the temperature control unit 100 shown in Fig. 2 (A), the first metal member 1 and the second metal member 2 constitute principal surfaces (surfaces having a largest area) of the temperature control unit. However, the present disclosure is not limited to the configuration shown in Fig. 2 (A). For example, the temperature control unit may have a configuration in which either one of the first metal member 1 or the second metal member 2 constitutes a principal surface and at least a portion of a side portion.

The first resin member 11 included in the temperature control unit 100 may be composed of a single continuous component, or may be separated into plural components. When the first resin member 11 is separated into plural components, at least a portion of a surface of each component is preferably fused with the second resin member, from the viewpoint of securing a tight sealing inside the temperature control unit.

In the temperature control unit 100 shown in Fig. 2 (A), the second resin member 12 is disposed at a side portion of the temperature control unit 100 and an internal portion of the temperature control unit 100.

The configuration in which the second resin member 12 is disposed inside the temperature control unit 100 may be produced by, for example, injecting a melted resin into an internal portion of the temperature control unit from a through-hole (gate) provided at a surface of the first metal member 1 or the second metal member 2.

The second resin member 12 included in the temperature control unit 100 may be composed of a single continuous component or may be separated into plural components.

The temperature control unit 100 shown in Fig. 2 (B) is different from the temperature control unit 100 shown in Fig. 2 (A) in that the second resin member 12 disposed inside the temperature control unit 100 penetrates through the first metal member 1 and the second metal member 2.

The temperature control unit 100 shown in Fig. 2 (C) is different from the temperature control unit 100 shown in Fig. 2 (A) in that the second resin member 12 disposed inside the temperature control unit 100 penetrates through the first metal member 1 and the second metal member 2, and an edge portion of the second resin member 12 that penetrates through the first metal member 1 and the second metal member 2 is covered with a cover member 13.

The temperature control unit 100 shown in Fig. 2 (D) is different from the temperature control unit 100 shown in Fig. 2 (A) in that the first resin member 11 has a space that is divided into a space at the side of the first metal member 1 and a space at the side of the second metal member 2.

The temperature control unit 100 shown in Fig. 2 (E) is different from the temperature control unit 100 shown in Fig. 2 (A) in that the first resin member 11 has a space that is divided into a space at the side of the first metal member 1 and a space at the side of the second metal member 2, and that the second resin member 12 is not disposed inside the temperature control unit 100.

The temperature control unit 100 shown in Fig. 2 (F) and (G) is different from the temperature control unit 100 shown in Fig. 2 (A) to (E) in that the first resin member 11 and the second resin member 12 are not fused with each other.

In the temperature control unit 100 shown in Fig. 2 (F) and (G), the first metal member 1 and the second metal member 2 may be joined with each other by a portion of the second resin member 12 being disposed therebetween, or by using an adhesive or the like, or may be merely in contact with each other. The first metal member 1 and the second metal member 2 may have a symmetric shape as shown in (F), or may have an asymmetric shape as shown in (G).

The temperature control unit 100 shown in Fig. 2 (H) is different from the temperature control unit 100 shown in Fig. 2 (A) in that the first resin member 11 constitutes a side portion of the temperature control unit 100.

The temperature control unit of the present disclosure may have an attachment portion for attaching the temperature control unit to a peripheral device.

When the temperature control unit has an attachment portion, any one of the first resin member, the second resin member, the first metal member or the second metal member may have an attachment portion, or any two or more thereof may have an attachment portion.

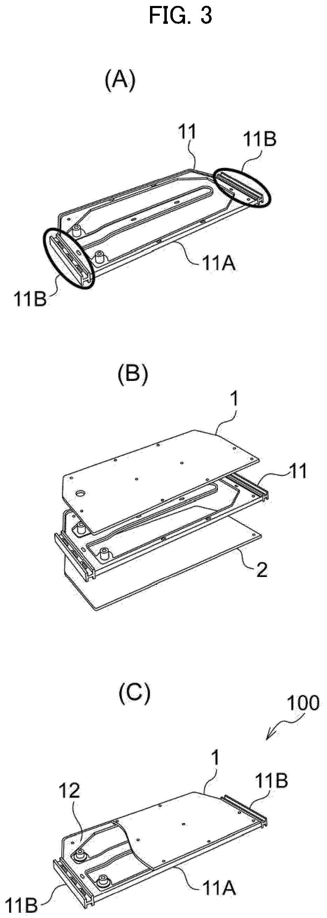

Fig. 3 is a schematic perspective view of a temperature control unit having a configuration in which the first resin member has an attachment portion.

As shown in Fig. 3 (A), the first resin member 11 has a main body 11A (a portion to be disposed between the metal members) and an attachment portion 11B.

As shown in Fig. 3 (B), the first resin member 11, having the main body 11A and the attachment portion 11B, is disposed between the first metal member 1 and the second metal member 2. Subsequently, as shown in Fig. 3 (C), the second resin member 12 is disposed at a region around a space for a fluid to flow, thereby obtaining the temperature control unit 100 in which the first resin member has an attachment portion.

The attachment portion 11B of the first resin member 11 may be integrally formed with the main body 11A. The first resin member 11 in which the attachment portion 11B is integrally formed with the main body 11A may be obtained by, for example, forming the main body 11A and the attachment portion 11B of the first resin member 11 at one time by injection molding.

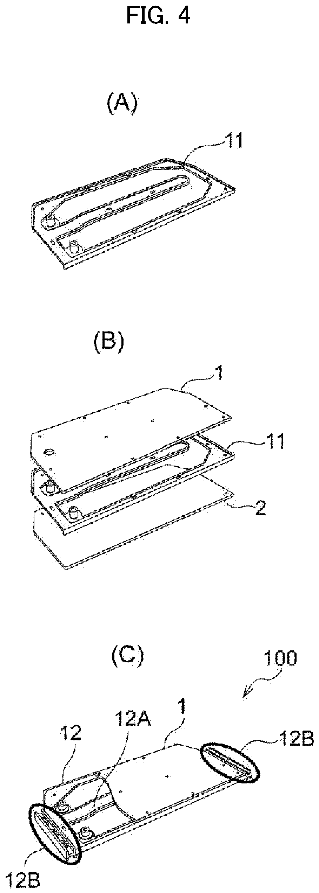

Fig. 4 is a schematic perspective view of a temperature control unit having a configuration in which the second resin member has an attachment portion.

As shown in Fig. 4 (A), the first resin member 11 has a main body 11A but not having an attachment portion.

As shown in Fig. 4 (B), the first resin member 11 is disposed between the first metal member 1 and the second metal member 2. Subsequently, as shown in Fig. 3 (C), the second resin member 12 is disposed at a region around a space for a fluid to flow.

The second resin member 12 has a main body 12A (a portion to be disposed between the metal members) and an attachment portion 12B.

The attachment portion 12B of the second resin member 12 may be integrally formed with the main body 12A. The second resin member 12 in which the attachment portion 12B is integrally formed with the main body 12A may be obtained by, for example, forming the main body 12A and the attachment portion 12B of the second resin member 12 at one time by injection molding.

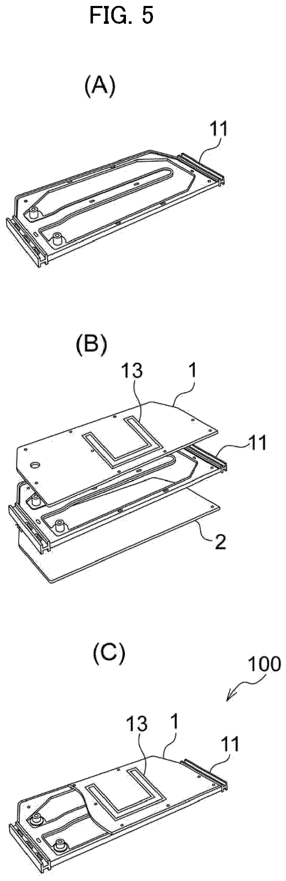

Fig. 5 is a schematic perspective view of a temperature control unit having a configuration in which the first metal member has an attachment portion.

The first resin member 11 shown in Fig. 5 (A) may have an attachment portion as shown in Fig. 3 (A), or may not have an attachment portion as shown in Fig. 4 (A).

As shown in Fig. 5 (B), the first resin member 11 is disposed between the first metal member 1 and the second metal member 2. The first metal member 1 has an attachment portion 13 at a surface thereof. Subsequently, as shown in Fig. 5 (C), the second resin member 12 is disposed at a region around a space for a fluid to flow.

The method for disposing the attachment portion 12 at a surface of the first metal member 1 is not particularly limited. For example, the attachment portion may include a resin and is joined with a surface of the first metal member 1, or may be fixed at a surface of the first metal member 1 with an adhesive, a screw or the like.

In Fig. 5, the attachment portion 13 is formed at a surface of the first metal member 1 prior to disposing the second resin member 12 between the first metal member 1 and the second metal member 2. However, the present disclosure is not limited thereto.

For example, the second resin member 12 and the attachment portion 13 may be disposed at one time by injection molding or the like (in that case, the material for the second resin member 12 may be the same as, or different from, the material for the attachment portion 13); or the attachment portion 13 may be disposed at a surface of the first metal member 1 after disposing the second resin member 12.

### (Metal member)

The metal member that constitutes the temperature control unit includes a metal. The type of the metal included in the metal member is not particularly limited, and may be selected depending on the purpose of the temperature control unit or the like. For example, the metal may be at least one selected from the group consisting of iron, copper, nickel, gold, silver, platinum, cobalt, zinc, lead, tin, titanium, chromium, aluminum, magnesium and manganese, or an alloy including any of these metals (such as stainless steel, brass or phosphor bronze).

From the viewpoint of heat conductivity, the metal is preferably selected from aluminum, aluminum alloy, copper and copper alloy, more preferably selected from copper and copper alloy.

From the viewpoint of reducing the weight and securing the strength, the metal is preferably selected from aluminum and aluminum alloy.

The first metal member and the second metal member may include a metal of the same kind as, or a metal of a different kind from, each other.

From the viewpoint of tightly joining the metal member with the resin member, a surface of the metal member, which is to be joined with the resin member, is preferably roughened.

When a surface of the metal member is roughened, a superficial portion of the resin member is embedded in a concave-convex structure formed at the roughened surface, thereby achieving a favorable joining strength.

The state of the concave-convex structure formed at a surface of the metal member is not particularly limited, as long as the metal component exhibits a sufficient degree of joining strength with respect to the resin member.

The average diameter of the concave portions in the concave-convex structure may be, for example, from 5 nm to 500 µm, preferably from 10 nm to 150 µm, more preferably from 15 nm to 100 µm.

The average depth of the concave portions in the concave-convex structure may be, for example, from 5 nm to 500 µm, preferably from 10 nm to 150 µm, more preferably from 15 nm to 100 µm.

When at least one of the average diameter or the average depth of the concave portion in the concave-convex structure is within the above range, the metal member tends to be joined with the resin member more tightly.

The average diameter or the average depth of the concave portions in the concave-convex structure may be measured using an electron microscope or a laser microscope. Specifically, the average diameter and the average depth of the concave portions may be given as an arithmetic average value of the values measured at arbitrarily selected 50 concave portions that are shown in micrographs of a surface and a cross-section of a surface of the metal component.

The method for performing the surface treatment to the metal member is not particularly limited, and may be selected from the known methods.

Examples of the method include a method using laser light as described in Japanese Patent No. 4020957; a method of immersing a surface of the metal member in an aqueous solution of an inorganic base such as NaOH or an inorganic acid such as HCl or HNO₃; a method of subjecting a surface of the metal member to anodization as described in Japanese Patent No. 4541153; a substitution crystallization method in which a surface of the metal member is etched with an aqueous solution including an acid-based etchant (preferably an inorganic acid, ferric ion or cupric ion) and optionally including manganese ions, aluminum chloride hexahydrate, sodium chloride or the like, as described in International Publication No. 2015/8847; a method of immersing a surface of the metal member in an aqueous solution of at least one selected from hydrazine hydrate, ammonia or a water-soluble amine compound (hereinafter, also referred to as an NMT method), as described in International Publication No. 2009/31632; a method of treating a surface of the metal member with a warm water, as described in JP-A No. 2008-162115; and a blast treatment.

It is possible to select a method for roughening depending on the material for the metal member, the type of desired specific surface roughness, and the like.

The surface of the metal member may be subjected to a treatment to add a functional group, in addition to the roughening treatment. The addition of a functional group to a surface of the metal member tends to increases the amount of chemical binding sites between the metal member and the resin member, thereby improving the joining strength thereof.

The treatment to add a functional group to a surface of the metal member is preferably performed either at the same time as the roughening treatment or after the roughening treatment.

The method for the addition of a functional group to a surface of the metal member is not particularly limited, and may be performed by various known methods.

Examples of the method include a method of immersing a surface of the metal member to a solution prepared by dissolving a chemical substance having a functional group to water or an organic solvent such as methyl alcohol, isopropyl alcohol, ethyl alcohol, acetone, toluene, ethyl cellosolve, dimethyl formaldehyde, tetrahydrofuran, methyl ethyl ketone, benzene, ethyl acetate ether or the like; a method of coating or spraying a surface of the metal member with a chemical substance having a functional group or a solution including the same; and a method of attaching a film including a chemical substance having a functional group to a surface of the metal member.

When the addition of a functional group is performed at the same time as the roughening treatment, examples of the method for the addition include performing wet etching, chemical conversion treatment, anode oxidation or the like, using a solution including a chemical substance having a functional group.

### (Resin member)

The resin included in the resin member is not particularly limited, and may be selected depending on the purpose of the temperature control unit or the like. Examples of the resin include thermoplastic resins (including elastomers) such as polyolefin resin, polyvinyl chloride, polyvinylidene chloride, polystyrene resin, AS resin, ABS resin, polyester resin, poly(meth)acrylic reins, polyvinyl alcohol, polycarbonate resin, polyamide resin, polyimide resin, polyether resin, polyacetal resin, fluorine resin, polysulfone resin, polyphenylene sulfide resin and polyketone resin; and thermosetting resins such as phenol resin, melamine resin, urea resin, polyurethane resin, epoxy resin and unsaturated polyester resin. The resin member may include a single kind of resin or may include two or more kinds in combination.

From the viewpoint of moldability, the resin included in the resin member is preferably a thermoplastic resin.

The first resin member and the second resin member may include a resin of the same kind as, or a resin of a different kind from, each other.

The first resin member preferably includes a thermoplastic resin when the second resin member includes a thermoplastic resin, and the first resin member preferably includes a thermosetting resin when the second resin member includes a thermosetting resin.

From the viewpoint of achieving a compatibility between the fist resin member and the second resin member, the first resin member and the second resin member preferably include a resin of the same kind.

In the present disclosure, the "resin of the same kind" refers to a resin that may have a different molecular weight or a different monomer type from the other resin, as long as the resin belongs to the same category as the other resin. For example, resins referred to as a polyolefin resin are regarded as the resins of the same kind, notwithstanding a difference in the molecular weight or the monomer type from each other.

It is also possible to achieve a high degree of compatibility by selecting a combination of resins that are highly chemically interactive with each other as the resins for the first resin member and the second resin member.

When it is difficult to visually determine a border of the fist resin member and the second resin member, the border may be determined by observing a section of a portion at which the first resin member and the second resin member are fused with each other with an optical microscope or a polarizing microscope, for example. Specifically, a portion at which a difference is observed in a crystalline structure of the resins included in the resin members, or a difference is observed in a state of orientation of a filler included in the resin members, may be determined as a border of the fist resin member and the second resin member.

The resin included in the resin member may include an additive of various kind. Examples of the additive include a filler, a thermal stabilizer, an antioxidant, a pigment, a weathering stabilizer, a flame retarder, a plasticizer, a dispersant, a lubricant, a releasing agent and an antistatic agent.

As necessary, the temperature control unit may have a component such as a joint that connects a channel disposed inside the temperature control unit to an external pipe, or a rib for reinforcement that is disposed at an exterior portion of the temperature control unit.

The component such as a joint or a rib may be integrally formed with the first resin member or the second resin member. For example, a joint may be integrally formed with the first resin member.

When the temperature control unit has a component, the component may include a resin and is joined with a surface of the metal member. The type of the resin included in the component is not particularly limited, and may be selected from the resins that may be included in the resin member as described above.

The size of the temperature control unit or the size of the members that constitute the temperature control unit is not particularly limited, and may be selected depending on the purpose of the temperature control unit.

The area of a principal surface of the temperature control unit may be, for example, in a range of from 50 cm² to 5,000 cm².

The thickness of the temperature control unit (when the thickness is not uniform, the minimum value of the thickness) may be, for example, from 1 mm to 150 mm, preferably from 5 mm to 50 mm. From the viewpoint of making the temperature control unit thinner, the thickness of the temperature control unit may be 20 mm or less.

The shape of the channel in the temperature control unit is not particularly limited, and the channel may be U-shaped, O-shaped, I-shaped, L-shaped or the like. As necessary, a component such as a heat sink may be disposed inside the channel.

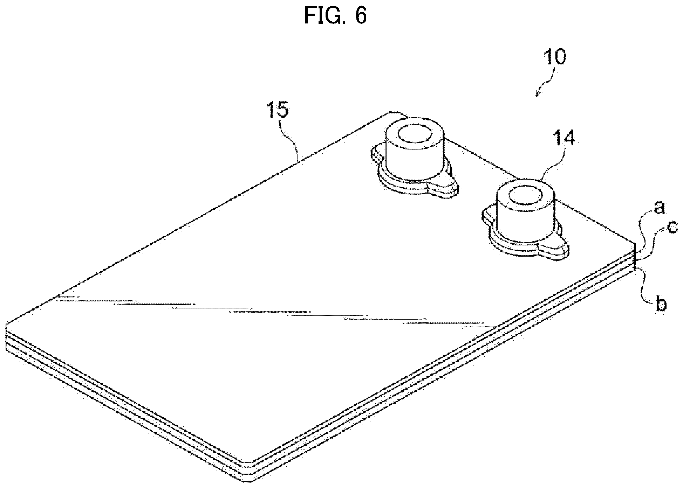

Fig. 6 is an example of an external appearance of the temperature control unit.

The temperature control unit 10 shown in Fig. 6 has a plate-shaped casing 15 and a pair of joint portions 14.

The casing 15 is formed from a first metal member a and a second member b that constitute principal surfaces of the casing 15; a second resin member c that constitutes a part of a side of the casing 15; and a first resin member that is disposed inside the casing and forms a channel (not shown in the drawing).

The joint portions 14 include a joint portion for supplying a fluid to a channel disposed inside the casing 15, and a joint portion for discharging a fluid from the casing 15.

While the joint portions 14 are disposed at the first metal portion a of the temperature control unit 10 in Fig. 6, the present disclosure is not limited to this configuration. For example, the joint portions 14 may be disposed at a side portion of the temperature control unit 10.

### <Purpose of temperature control unit>

The purpose of the temperature control unit of the present disclosure is not particularly limited. For example, the temperature control unit is suitably used for cooling a heating element such as a CPU for computers or a secondary battery for electric vehicles. In addition, the temperature control unit is suitably used for any purpose that requires temperature control, such as air-conditioning equipment, hot-water supply equipment, and power-generation equipment.

### <Method for manufacturing temperature control unit>

The method for manufacturing a temperature control unit is a method for manufacturing a temperature control unit, the method comprising:
disposing the first metal member, the second metal member and the first resin member in a mold; and supplying a melted resin to the mold.

In the present method, the resin being melted (including being softened) is supplied to the mold, and the resin solidifies while being in contact with at least a portion of a surface of the first metal member and the second metal member, and forms the second resin member.

In the present method, it is possible to allow the melted resin to contact with the first resin member. In that case, a state in which the first resin member is fused with the second resin member, which is formed by solidification of the melted resin, is created.

As necessary, a portion of the first resin member to be in contact with the melted resin may be heated with a heater or the like, in order to facilitate the fusion bonding with the second resin member.

The present method may include, prior to disposing the first metal member, the second metal member and the first resin member in a mold, subjecting a surface of at least one of the first metal member or the second metal member to a roughening treatment.

By subjecting a surface of at least one of the first metal member or the second metal member to a roughening treatment, the joint strength at an interface with the second metal member may be increased, and a temperature control unit having a more tightly sealed internal portion may be obtained.

The details and preferred embodiments of the first metal member and the second metal member used in the present method are the same as the details and preferred embodiments of the first metal member and the second metal member included in the temperature control unit as described above.

The details and preferred embodiments of the resin used in the present method are the same as the details and preferred embodiments of the resin included in the temperature control unit as described above.

As necessary, the method may include a process of disposing a component such as a joint or a rib. The component such as a joint or a rib may be integrally formed with the first resin member or the second resin member. For example, a joint may be integrally formed with the first resin member.

The details and preferred embodiments of the temperature control unit manufactured by the present method are the same as the details and preferred embodiments of the temperature control unit as described above. Namely, the present method may be a method for manufacturing the temperature control unit as described above.

The disclosure of Japanese Patent Application No. 2020-200637 is incorporated herein by reference in its entirety.

All publications, patent applications, and technical standards mentioned in the present specification are incorporated herein by reference to the same extent as if each individual publication, patent application, or technical standard was specifically and individually indicated to be incorporated by reference.

## Claims

1. A temperature control unit, comprising a first metal member, a second metal member, a first resin member that is disposed between the first metal member and the second metal member, and a second resin member,
the first resin member having a shape corresponding to a space for a fluid to flow between the first metal member and the second metal member, and
the second resin member being joined with at least a portion of a surface of at least one of the first metal member or the second metal member.

2. The temperature control unit according to claim 1, wherein the second resin member is joined with at least a portion of a surface of each of the first metal member and the second metal member.

3. The temperature control unit according to claim 1 or claim 2, wherein the first metal member and the second metal member are not joined with the first resin member.

4. The temperature control unit according to claim 1, wherein the first resin member is fused with at least a portion of a surface of the second resin member.

5. The temperature control unit according to claim 4, wherein an interface at which at least one of the first metal member or the second metal member is joined with the second resin member, and an interface at which the first resin member and the second resin member are fused, are adjacent to each other.

6. The temperature control unit according to any one of claim 1 to claim 5, wherein the surface of at least one of the first metal member or the second metal member, the portion of which is joined with the second resin member, is roughened.

7. The temperature control unit according to any one of claim 1 to claim 6, wherein a state of j oining is such that a portion of the second resin member is embedded in a concave-convex structure at the surface of at least one of the first metal member or the second metal member.

8. The temperature control unit according to any one of claim 1 to claim 7, wherein each of the first metal member and the second metal member independently comprises a metal selected from the group consisting of iron, copper, nickel, gold, silver, platinum, cobalt, zinc, lead, tin, titanium, chromium, aluminum, magnesium and manganese, or an alloy comprising the metal.

9. The temperature control unit according to any one of claim 1 to claim 8, wherein the first metal member and the second metal member comprise a metal of the same kind as, or a metal of a different kind from, each other.

10. The temperature control unit according to any one of claim 1 to claim 9, wherein the first resin member and the second resin member comprise a resin of a same kind.

11. The temperature control unit according to any one of claim 1 to claim 10, wherein the first resin member has an attachment portion for attaching the temperature control unit to a peripheral device.

12. The temperature control unit according to claim 11, wherein the attachment portion is integrally formed with a main body of the first resin member.

13. The temperature control unit according to any one of claim 1 to claim 10, wherein the second resin member has an attachment portion for attaching the temperature control unit to a peripheral device.

14. The temperature control unit according to claim 13, wherein the attachment portion is integrally formed with a main body of the second resin member.

15. The temperature control unit according to any one of claim 1 to claim 10, wherein at least one of the first metal member or the second metal member has an attachment portion for attaching the temperature control unit to a peripheral device.

16. The temperature control unit according to claim 15, wherein at least one of the first resin member or the second resin member has an attachment portion for attaching the temperature control unit to a peripheral device.

17. The temperature control unit according to claim 15 or claim 16, wherein the attachment portion comprises a resin and is joined with a surface of at least one of the first metal member or the second metal member.

18. A method for manufacturing the temperature control unit according to any one of claim 1 to claim 17, the method comprising:
disposing the first metal member, the second metal member and the first resin member in a mold; and
supplying a melted resin to the mold.

19. The method for manufacturing the temperature control unit according to claim 18, the method further comprising, prior to disposing the first metal member, the second metal member and the first resin member in a mold, subjecting a surface of at least one of the first metal member or the second metal member to a roughening treatment.
